# EUROPÄISCHE PATENTANMELDUNG

(11) **EP 0 823 765 A1**
(43) Veröffentlichungstag der Anmeldung: **11.02.1998**
(21) Anmeldenummer: 96112647.1
(22) Anmeldetag: 06.08.1996
(51) Int. Cl.: H02H 7/085, G01R 31/327

(54) **Verfahren zur Kurzschlussüberwachung**

(71) Anmelder: Hella KG Hueck & Co., 59552 Lippstadt (DE)
(72) Erfinder: Trinschek, Martin, 59067 Hamm (DE)

(57) **Zusammenfassung**

Beschrieben wird ein Verfahren und eine Schaltungsanordnung zur Kurzschlußüberwachung angesteuerter Lastschalter einer Motorbrücke, bestehend aus vier elektronischen Lastschaltern, die zu einer Brückenschaltung verbunden sind, in deren Brückendiagonale ein Motor geschaltet ist.

In einigen Anwendungsfällen ist es erforderlich zu wissen, ob ein angesteuerter Motor jederzeit in die umgekehrte Drehrichtung umgesteuert werden kann. Daraus folgt die Notwendigkeit, auch während des Betriebes die aktiven Brückenzweige auf Kurzschlüsse in den Lastschaltern zu überprüfen, Kurzschlüsse in einzelnen Lastschaltern verursachen bei einer Richtungsänderung einen Kurzschluß über die Betriebsspannung; der Motor kann somit nicht mehr angesteuert werden. Mit dem beschriebenen Verfahren und der das Verfahren ausführenden Schaltungsanordnung können bei laufendem Motor die zugehörigen Lastschalter auf interne oder externe Kurzschlüsse überprüft werden. Hierzu wird der zu prüfende Lastschalter sehr kurzzeitig abgeschaltet und der Spannungswert an einem Verbindungspunkt zwischen dem zu prüfenden Lastschalter und dem Motor unter Berücksichtigung der vom freilaufenden Motor erzeugten Generatorspannung überwacht.

## Beschreibung

Die Erfindung betrifft ein Verfahren und eine Schaltungsanordnung zur Kurzschlußüberwachung angesteuerter Lastschalter einer Motorbrücke, bestehend aus vier elektronischen Lastschaltern, die zu einer Brückenschaltung verbunden sind, in deren Brückendiagonale ein Motor geschaltet ist.

Elektrische Motoren kommen insbesondere als Stellmotoren in modernen Kraftfahrzeugen in großer Anzahl zur Anwendung. Um eine Ansteuerung in beiden Drehrichtungen zu ermöglichen, wird der Stellmotor dabei zumeist in eine Brückenschaltung aus vier elektronischen Lastschaltern geschaltet. Zur Betätigung des Motors werden bekanntermaßen jeweils zwei in der Brückenschaltung einander diagonal gegenüberliegende Lastschalter angesteuert.

Nachteilig dabei ist, daß bei einem Kurzschluß in einem angesteuerten Lastschalter ein Umsteuern des Motors in die entgegengesetzte Drehrichtung nicht mehr möglich ist, was zu unangenehmen oder sogar gefährlichen Situationen führen kann.

So ist es in der StVZO vorgeschrieben, daß dynamische Leuchtweiteregler (d.h. Leuchtweiteregler, bei denen die Positionierung der Scheinwerfer automatisch aufgrund von Sensorsignalen erfolgt, welche z.B. die Fahrzeugeinfederung erfassen), daß ein Aufblenden der Scheinwerfer nur erlaubt ist, wenn auch jederzeit ein Abblenden möglich ist. Um diese Vorschrift in jedem Fall erfüllen zu können, müssen beim Aufblendvorgang die angesteuerten Lastschalter der Brückenschaltung ständig bezüglich eines möglichen internen oder externen Kurzschlusses überprüft werden.

Elektrische Fensterheberanlagen in Kraftfahrzeugen können zu besonders kritischen Situationen führen. Es sei angenommen, ein schließendes Fenster klemme ein Körperteil eines Fahrgastes ein, wobei einer der den Fensterhebermotor bestromenden Lastschalter in der Motorbrücke defekt sei und einen Kurzschluß aufweise. Durch diesen Kurzschluß ist einfalls noch ein Abschalten des Motors über den in der Motorbrücke diagonal gegenüberliegenden Lastschalter möglich, nicht jedoch eine Richtungsumkehr des Motors, das heißt, das eingeklemmte Opfer bleibt in seiner mißlichen Lage gefangen. Um dieses zu verhindern ist daher eine Überwachung der angesteuerten Lastschalter bezüglich eines internen oder externen Kurzschlusses, und zwar zumindest während des Schließvorganges der Fensterscheibe unbedingt erforderlich.

Ein Verfahren und eine Schaltungsanordnung zur Überwachung von elektromotorischen Stellgliedern in einer Brückenschaltung ist aus der EP 0 413 893 A2 bekannt. Die Prüfung der Motorbrücke auf verschiedene Fehlerzustände erfolgt hierbei durch zwei in die Brückenschaltung eingefügte Strommeßwiderstände.

Solche Strommeßwiderstände müssen möglichst niederohmig sein, um die durch sie bewirkte Verlustleistung möglichst gering zu halten. Sehr niederohmige Meßwiderstände ausreichender Genauigkeit sind aber recht kostenaufwendig. Auch ist der Schaltungsaufwand relativ hoch, um die an den niederohmigen Meßwiderständen abfallenden, sehr kleinen Spannungen auszuwerten; in der EP 0 413 893 A2 werden hierzu jeweils als integrierte Schaltungen ausgeführte Differenzverstärker vorgesehen. Den jeweils aufgetretenen Fehler bestimmt ein Mikrocomputer nach Vergleich der erfaßten Stromwerte mit gespeicherten Sollwerten aus einer umfangreichen Tabelle.

Damit erweist sich sowohl dieses vorbekannte Verfahren, als auch die Schaltungsanordnung zur Überprüfung von angesteuerten Lastschaltern als relativ aufwendig, insbesondere auch als kostenaufwendig.

Es ist daher die Aufgabe der Erfindung, die Lastschalter einer Motorbrücke während des Betriebs des Motors bezüglich interner und externer Kurzschlüsse, und zwar auf eine möglichst einfache und kostengünstige Weise, zu überprüfen.

Diese Aufgabe wird durch die kennzeichnenden Merkmale des Anspruches 1 gelöst. Durch das erfindungsgemäße Verfahren ist es auf einfache und sichere Weise möglich, zu prüfen, ob einer der zur Motorbestromung angesteuerten Lastschalter einen internen oder externen Kurzschluß aufweist, was eine wesentliche Voraussetzung dafür ist, daß der Motor, insbesondere in einem Notfall, schnell in die entgegengesetzte Drehrichtung umgeschaltet werden kann.

Der zu überprüfende Lastschalter wird hierzu sehr kurzzeitig ( d.h. für circa eine Millisekunde ) abgeschaltet und die Veränderung des Spannungswertes am Verbindungspunkt zwischen Lastschalter und Motor erfaßt. Da hierbei die vom freilaufenden Motor erzeugte Generatorspannung berücksichtigt wird, kann die Überprüfung des Lastschalters bei laufendem Motor erfolgen, wobei aufgrund des sehr schnellen Prüfvorganges dessen kurzzeitige Abschaltungen von einem Anwender gar nicht bemerkt wird.

Die das erfindungsgemäße Verfahren ausführende Schaltungsanordnung kann in verschiedenen Ausbaustufen realisiert werden. So kann vorgesehen werden, nur die Lastschalter zu prüfen, die den Motor in eine, bezüglich von Fehlfunktionen, kritische Drehrichtung steuern. Durch Zuordnung eines Schwellendetektors zu jedem der vier Lastschalter kann aber auch die gesamte Motorbrücke geprüft werden.

Wird ein Fehler festgestellt, so wird die Ansteuerung der Lastschalter beendet. Aus Sicherheitsgründen ist es vorteilhaft, im Fehlerfall die Spannungsversorgung der gesamten Motorbrücke zu unterbrechen, zum Beispiel, indem die Betriebsspannung für die Motorbrücke über den Arbeitskontakt eines Relais geführt wird, welches im Fehlerfall abgeschaltet wird.

Sowohl die Steuerungs- als auch die Überwachungsfunktionen können vorteilhafterweise durch einen einfachen Mikroprozessor erledigt werden, wobei das hierzu erforderliche Steuer- und Prüfprogramm sehr einfach ist.

Verschiedene Möglichkeiten gibt es auch hinsichtlich der einsetzbaren Schwellendetektoren. So reicht hierfür ein einfacher Transistor mit einem Spannungsteiler zur Einstellung der Schaltschwelle am Steuereingang, sowie ein Widerstand zur Pegelanpassung bereits aus, um ein durch einen Mikroprozessor auswertbares, digitales Signal zu erzeugen.

Höhere Ansprüche an die Genauigkeit erfüllen Komparatoren oder Analog-Digital-Wandler als Schwellendetektoren, wobei der schaltungstechnische Aufwand hier etwas höher liegt.

Im folgenden soll das erfindungsgemäße Verfahren, sowie eine Schaltungsanordnung zur Ausführung dieses Verfahrens anhand eines in der Zeichnung dargestellten Ausführungsbeispieles näher erläutert werden.

Es zeigen:
- Figur 1: eine Schaltungsanordnung zur Ausführung des erfindungsgemäßen Verfahrens,
- Figur 2: ein Diagramm zur zeitlichen Darstellung verschiedener in der Schaltungsanordnung der Figur 1 auftretender Signale.

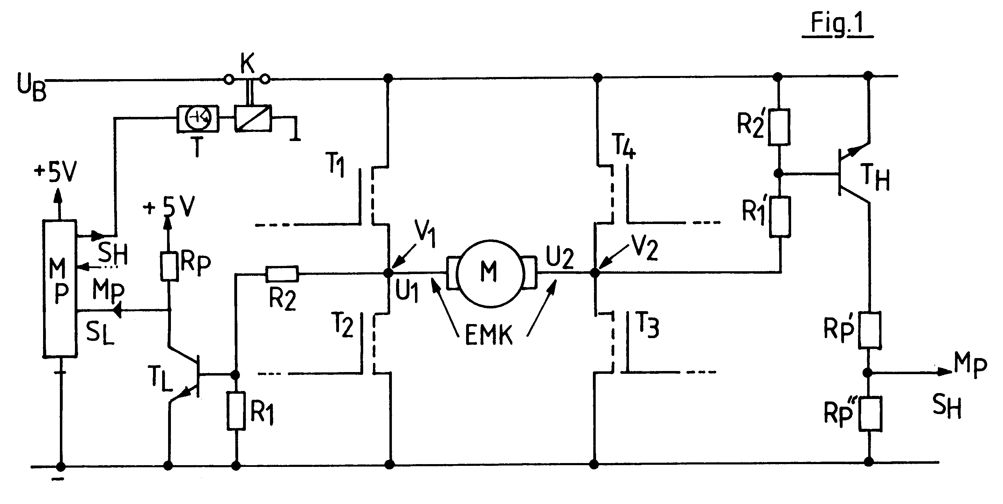

In der Figur 1 ist eine Schaltungsanordnung dargestellt, die eine Brückenschaltung aus vier elektronischen Lastschaltern (T1,T2,T3,T4), hier dargestellt als Leistungs-FETs. Die Beschaltung der Steueranschlüsse der Lastschalter (T1,T2,T3,T4) ist in der Figur nicht dargestellt; man kann sich die Steueranschlüsse mit einem geeigneten ( nicht dargestellten ) Ansteuerbausteins oder besonders vorteilhaft, mit den Ports eines Mikroprozessors (MP) verbunden vorstellen.

In die Brückendiagonale der Lastschalter (T1,T2,T3,T4) ist ein elektrischer Motor (M) geschaltet, wobei die Verbindungspunkte zwischen Motor und Lastschalter (T1,T2,T3,T4), im folgenden als V1 und V2, und die an den Verbindungspunkten (V1,V2) vorliegenden Spannungen als U1 und U2 bezeichnet werden.

Diese Spannungen (U1,U2) werden durch zwei Schwellendetektoren (R1,R2,TL,RP;R1',R2',TH,RP',Rp2') erfaßt und bezüglich des Über- oder Unterschreitens vorgegebener Schwellenwerte (US1,US2) überwacht.

Die Schwellendetektoren bestehen hier aus jeweils einem Transistor (TL,TH), welchem die Spannung (U1,U2) am jeweiligen Verbindungspunkt (V1,V2) über einen Spannungsteiler (R1,R2;R1',R2') zugeführt wird. Die Dimensionierung der Spannungsteilerwiderstände (R1,R2;R1',R2') gibt hierbei die Schaltschwelle des Transistors (TL,TH) vor.

Am Kollektorjedes Transistors (TL,TH) wird ein Statussignal (SL,SH) entnommen, welches von der erfaßten Spannungshöhe (U1,U2) am Verbindungspunkt (V1,V2) abhängt. Durch einen bzw. zwei Vorwiderstände (RP;RP',RP2') zur Pegelanpassung können die Statussignale (SL,SH) direkt mit logischen Schaltkreisen, und besonders vorteilhaft, wie hier dargestellt, Eingängen eines Mikroprozessors (MP) zugeführt werden.

Anstelle der hier dargestellten Transistorschaltung können als Schwellendetektoren natürlich auch Komparatoren oder Analog-Digital-Wandler zur Anwendung kommen, wobei sich eine besonders hohe Detektionsgenauigkeit der Schaltschwelle erzielen läßt. Demgegenüber zeichnet sich die dargestellte Transistorschaltung durch einen besonders geringen Schaltungsaufwand aus.

Aufgrund der Statussignale (SL,SH) erkennt der Mikroprozessor (MP), ob in der Brückenschaltung einer der die aktuelle Drehrichtung des Motors (M) steuernden Lastschalter (S2,S4) einen internen oder externen Kurzschluß aufweist. Wird ein Kurzschluß in einem der Lastschalter (T2,T4) festgestellt, so beendet der Mikroprozessor (MP) die Ansteuerung sämtlicher angesteuerter Lastschalter (T2,T4) bzw. öffnet über den Schaltverstärker (T) den Relais-Arbeitskontakt (K) und trennt so die Motorbrücke von der Betriebsspannung (UB).

Eine Brückenschaltung funktioniert bekanntermaßen derart, daß zur Betätigung des Motors (M) jeweils zwei diagonal gegenüberliegende Lastschalter (T1,T3 bzw. T2,T4) angesteuert werden, um durch wechselweises Anschalten der Verbindungspunkte (V1,V2) entweder an Massepotential bzw. an das Potential der Betriebsspannung (UB) den Motor entweder in die eine oder die entgegengesetzte andere Drehrichtung zu steuern.

Eine wesentliche Funktion der dargestellten Schaltungsanordnung ist es, sicherzustellen, daß über die angesteuerten Lastschalter (T2,T4) der in die eine Drehrichtung gesteuerten Motor (M) jederzeit in die entgegengesetzte Drehrichtung umgesteuert werden kann. Um dieses sicherzustellen ist es notwendig, daß weder der Lastschalter T2 noch der Lastschalter T4 einen internen oder externen Kurzschluß aufweist, da sonst bei Ansteuerung des Lastschalterpaares (T1,T3) zu einem Kurzschluß über zwei in Reihe liegende Lastschalter (T1,T2 bzw. T3,T4) kommt, wodurch eine Ansteuerung des Motors in Gegenrichtung nicht mehr möglich ist, was je nach Anwendung zu unangenehmen oder sogar gefährlichen Situationen führen kann.

So könnte es beispielsweise vorkommen, daß ein durch einen elektrischen Leuchtweiteregler aufgeblendeter Scheinwerfer nicht mehr abblendbar ist oder schlimmer, wenn bei einem elektrischen Fensterheber ein Körperteil in den sich schließenden Fensterspalt geklemmt wird und sich das Fenster intern nicht mehr öffnen läßt.

Wie diese Beispiele zeigen, ist bei vielen Anwendungen eine Drehrichtung des Motors (M) als besonders kritisch anzusehen, im Beispiel des Fensterhebers ist das die Drehrichtung, die die Fensterscheibe in Schließrichtung bewegt. Ein Versagen der Motorsteuerung, wenn sich die Scheibe gerade öffnet, kann dagegen als ungefährlich betrachtet werden.

Daher ist es aus Sicherheitsgründen ausreichend, nur die Lastschalter für die kritische Drehrichtung des Motors (M) (hier T2 und T4) bezüglich eines Kurzschlusses zu prüfen, wie dies in der Figur 1 vorgesehen ist.

Selbstverständlich kann aber für die Lastschalter (T1,T3) ebenfalls eine Kurzschlußüberprüfung, nämlich durch einfaches Hinzufügen zweier weiterer Schwellendetektoren, vorgesehen werden.

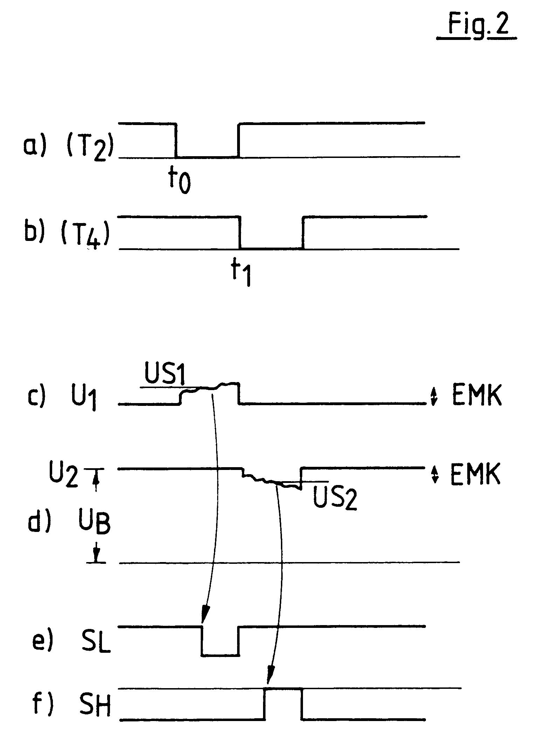

Wie die Kurzschlußprüfung der angesteuerten Lastschalter (T2,T4) erfolgt, sei im folgenden unter Hinzunahme der Figur 2 erläutert. In der Figur 2 zeigen die Diagramme a) und b) die zeitlichen Verläufe der Ansteuersignale an den elektronischen Lastschaltern (T2, T4); Diagramm c) und d) zeigen den entsprechenden Verlauf der Spannungen (U1,U2) an den Verbindungspunkten (V1,V2) und die Diagramme e) und f) den Verlauf der Statussignale (SL,SH), welche die Transistoren (TL,TH) an den Mikroprozessor (MP) geben.

In einem definierten Zeitpunkt to wird der Lastschalter T2 abgeschaltet. Aufgrund der vom nun freilaufenden Motor (M) erzeugten Generatorspannung (EMK) steigt am Verbindungspunkt V1 die Spannung U1 an, bis sie den Schwellenwert US1 erreicht. Dann wird durch U1>=US1 der Transistor TL durchgesteuert, wodurch das Statussignal SL auf LOW-Potential gezogen wird. Ist der Lastschalter T2 durch einen internen oder externen Kurzschluß gebrückt, so steigt die Spannung U1 zu diesem Zeitpunkt nicht an; damit bleibt auch das Statussignal SL auf HIGH-Potential, wodurch der Kurzschluß im T2-Zweig erkannt werden kann. Liegt ein Kurzschluß vor, so kann der Mikroprozessor (MP) die Betriebsspannung (UB) der Motorbrücke über den Relaiskontakt (K) sofort abschalten. Liegt kein Fehler vor, so wird zum Zeitpunkt t1 der Lastschalter T2 zu- und der Lastschalter T4 abgeschaltet. Hier erfolgt die Erkennung analog: liegt kein Kurzschluß im T4-Zweig vor, so wird aufgrund des Spannungsabfalls am Verbindungspunkt V2: U2<(UB-US2) der Transistor TH durchgeschaltet und das Statussignal SH auf HIGH-Potential geschaltet. Im Kurzschlußfall bleibt dagegen der Transistor TH abgeschaltet und das Statussignal SH auf LOW. Die Überprüfung beider Lastschalter (T2,T4) ist nach ca. 1-2 Millisekunden abgeschlossen und für den Benutzer nicht wahrnehmbar.

### Bezugszeichenliste

### Verfahren zur Kurzschlußüberwachung

- EMK: Generatorspannungswert
- K: Relais ( arbeits) kontakt
- M: Motor
- MP: Mikroprozessor
- RP,RP',RP2': Vorwiderstände ( zur Pegelanpassung)
- R1,R2;R1',R2': Spannungsteiler
- R1,R2,TL,RP;R1',R2',TH,RP',RP2': Schwellendetektoren
- SL,SH: Statussignale
- TL,TH: (bipolare) Transistoren
- T: Schaltverstärker
- T1,T2,T3,T4: (elektronische) Lastschalter
- UB: Betriebsspannung
- US1,US2: Schwellenwerte
- U1,U2: Spannungen (an den Verbindungspunkten V1,V2)
- V1,V2: Verbindungspunkte

## Patentansprüche

1. Verfahren zur Kurzschlußüberwachung angesteuerter Lastschalter einer Motorbrücke, bestehend aus vier elektronischen Lastschaltern (T1,T2,T3,T4) die zu einer Brückenschaltung verbunden sind, in deren Brückendiagonale ein Motor (M) geschaltet ist, dadurch gekennzeichnet
- daß die Ansteuerung des zu prüfenden Lastschalters (T2,T4) kurzzeitig unterbrochen wird
- daß der Wert der Spannung (U1,U2) am Verbindungspunkt (V1,V2) zwischen dem zu prüfenden Lastschalter (T2,T4) und dem Motor (M) durch einen Schwellendetektor (R1,R2,TL,RP;R1',R2',TH,RP',RP'') erfaßt wird
- daß der Schwellendetektor (R1,R2,TL,RP;R1',R2',TH,RP',RP'') ein vorgegebenes Statussignal (SL,SH) erzeugt, welches den zu prüfenden Lastschalter (T2,T4) als kurzschlußfrei signalisiert, wenn der am Verbindungspunkt (V1,V2) erfaßte Wert der Spannung (U1,U2) dem Wert der Spannung (U2,U1) am Verbindungspunkt (V2,V1) des Motors (M) mit dem in der Brückenschaltung diagonal gegenüberliegenden Lastschalter (T4,T2) zuzüglich einem vorzeichenbehafteten Bruchteil des vom freilaufenden Motor (M) erzeugten Generatorspannungswertes (EMK) einen vorgegebenen Schwellenwert erreicht.

2. Verfahren nach Anspruch 1, dadurch gekennzeichnet, daß der Schwellendetektor (R1,R2,TL,RP;R1',R2',TH,RP',RP'') nicht das vorgegebene Statussignal (SL,SH) erzeugt und damit einen Kurzschluß in dem zu prüfenden Lastschalter (T2,T4) signalisiert, wenn der erfaßte Spannungswert (U1,U2) nicht während der Ansteuerungsunterbrechung des zu prüfenden Lastschalters (T2,T4) den Wert erreicht, welcher dem Schwellenwertes (US1,US2) entspricht.

3. Verfahren nach Anspruch 1, dadurch gekennzeichnet, daß zwei einander in der Brückenschaltung diagonal gegenüberliegende Lastschalter (T1,T3 bzw. T2,T4) jeweils nacheinander geprüft werden.

4. Verfahren nach Anspruch 1, dadurch gekennzeichnet, daß jedem der vier Lastschalter (T1,T2,T3,T4) jeweils ein eigener Schwellendetektor zugeordnet ist.

5. Verfahren nach Anspruch 1, dadurch gekennzeichnet, daß beim Nichtauftreten des vorgegebenen Statussignales (SL,SH) während der Ansteuerungsunterbrechung eines zu prüfenden Lastschalters (T2,T4) die Ansteuerung aller Lastschalter (T1,T2,T3,T4) beendet wird.

6. Verfahren nach Anspruch 1 oder 5, dadurch gekennzeichnet, daß beim Nichtauftreten des vorgegebenen Statussignales (SL,SH) während der Ansteuerungsunterbrechung eines zu prüfenden Lastschalters (T2,T4) mittels eines Relaiskontaktes (K) die Motorbrückenschaltung von der Betriebsspannung (UB) getrennt wird.

7. Verfahren nach Anspruch 1, dadurch gekennzeichnet, daß die Dauer der Ansteuerungsunterbrechung eines zu prüfenden Lastschalters (T2,T4) in der Größenordnung einer Millisekunde liegt.

8. Schaltungsanordnung zur Ausführung eines Verfahrens nach Anspruch 1, dadurch gekennzeichnet, daß sowohl die Ansteuerung der Lastschalter (T1,T2,T3,T4) wie auch die Auswertung der Statussignale (SL,SH) durch einen Mikroprozessor (MP) erfolgt.

9. Schaltungsanordnung nach Anspruch 8, dadurch gekennzeichnet, daß der Schwellendetektor ein mit einem Spannungsteiler (R1,R2 bzw. R1',R2') beschalteter bipolarer Transistor (TL,TH) oder ein Komparator oder ein Analog-Digital-Wandler ist.
